# EUROPEAN PATENT SPECIFICATION

(11) **EP 4 254 490 B1**
(45) Date of publication and mention of the grant of the patent: **09.09.2026**
(21) Application number: 21896665.3
(22) Date of filing: 22.10.2021
(51) Int. Cl.: H10W 72/30, H10W 90/00

(54) **SEMICONDUCTOR DEVICE ASSEMBLY, CRIMPING POWER SEMICONDUCTOR MODULE, AND MANUFACTURING METHOD**
HALBLEITERBAUELEMENTANORDNUNG, CRIMP-LEISTUNGSHALBLEITERMODUL UND HERSTELLUNGSVERFAHREN
ENSEMBLE DISPOSITIF À SEMI-CONDUCTEUR, MODULE SEMI-CONDUCTEUR DE PUISSANCE DE SERTISSAGE ET PROCÉDÉ DE FABRICATION

(30) Priority: 27.11.2020 CN 202011362069
(43) Date of publication of application: 04.10.2023
(73) Proprietor: Zhuzhou CRRC Times Semiconductor Co., Ltd., Zhuzhou, Hunan 412005 (CN)
(72) Inventor: CHANG, Guiqin, Zhuzhou, Hunan 412005 (CN); SHI, Tingchang, Zhuzhou, Hunan 412005 (CN); LUO, Haihui, Zhuzhou, Hunan 412005 (CN); LI, Han, Zhuzhou, Hunan 412005 (CN); LI, Xingfeng, Zhuzhou, Hunan 412005 (CN); PENG, Yongdian, Zhuzhou, Hunan 412005 (CN); LI, Liangxing, Zhuzhou, Hunan 412005 (CN); ZHANG, Wenhao, Zhuzhou, Hunan 412005 (CN); DONG, Guozhong, Zhuzhou, Hunan 412005 (CN)
(74) Representative: Petraz, Gilberto Luigi
(86) International application number: PCT/CN2021/125579
(87) International publication number: WO 2022/111163

(56) References cited:
- CN-A- 1 264 175
- CN-A- 103 890 941
- CN-A- 105 679 750
- CN-A- 110 828 433
- CN-A- 112 636 054
- US-A1- 2014 225 245

## Description

### Field of the present invention

The present disclosure relates to the field of power semiconductors, and more specifically, to a semiconductor device assembly, a crimping-type power semiconductor module, and manufacturing methods therefor.

### Background of the present invention

With the continuous expansion of the application fields of Insulated Gate Bipolar Transistor (IGBT) devices, especially in the application fields requiring high level of power density and high reliability, such as flexible DC electric transmission, large-scale offshore wind power generation, mining truck frequency converters, etc., at present, a high-power crimping-type IGBT has gradually replaced a conventional welding-potting IGBT device and become a preferred device to be adopted in the above high-end application fields, because the power capacity and reliability of the device has been greatly improved due to its unique design of lead wire-free bonding, welding-free layer and double-sided heat dissipation as well as its technical advantages such as a press fitting mode capable of connecting in series, a stable current conduction mode in case of failure, etc.

Based on the above application fields, higher requirements are put forward as following for the application of a crimping-type IGBT module: firstly, as to explosion-proof, it is required that no explosion happens in case of failure of a module or that an energy impact in case of explosion can be blocked by an insulation outer frame; secondly, as to sealing, a chip is required to be packaged in a completely sealed cavity, which can prevent external moisture from being immersed so as to improve the reliability; and thirdly, as to a characteristic of failure triggered short-circuit, it is required that the chip can form a reliable and continuous current conduction path (that is, an open circuit should be avoided) in a failure mode.

In view of the above background and requirements, many main manufacturers of semiconductor devices have developed structures of a crimping-type IGBT module on target for related application fields. CN1190838C discloses a power semiconductor module, comprising a base plate, a cover plate, at least one semiconductor chip, first main electrodes, second main electrodes, elastic electric contact elements and pillars. However, in the structure described in this patent, there are many stacked material layers so that there will be many contact interfaces, which means that the thermal resistance of the device is large, thereby limiting further expansion of power capacity. Also, since each chip corresponds to an independent bypass busbar structure, when a single chip fails, the current paths of the rest chips cannot form a current conduction path through this single chip, thereby limiting the current conduction performance in case of failure. Moreover, the structure described in this patent is subjected to no sealing, and thus cannot prevent water vapor and/or other substances from entering the interior of the power semiconductor module such that ability of the module to adapt to harsh environments is greatly weakened. CN108701667A discloses a semiconductor device assembly, comprising: a plurality of semiconductor units transversely spaced from one another, a conductive and extensible layer-patterned flat separator, a ceramic packaging shell, and a sealing module structure. In this patent, the conductive and extensible layer has a flat and thin sheet structure. If a single chip fails, the conductive and extensible layer will be fused and carbonized when a large current flows through the chip, and it is prone to form an isolation layer with high resistance such that the characteristic of failure triggered short-circuit of the module is poor. US201225245 discloses a semiconductor device assembly, comprising a main circuit subassembly and a gate subassembly , wherein the main circuit subassembly comprises a plurality of main circuit conductive mechanisms and a main circuit bypass mechanism , and each of the main circuit conductive mechanisms comprises a semiconductor chip and a main circuit conductive pillar having one end in contact with the semiconductor chip through a pad. CN1264175 also discloses a semiconductor device assembly, comprising a main circuit subassembly and a gate subassembly, wherein the main circuit subassembly comprises a plurality of main circuit conductive mechanisms and a main circuit bypass mechanism , and each of the main circuit conductive mechanisms comprises a semiconductor chip and a main circuit conductive pillar having one end in contact with the semiconductor chip through a pad.

### Summary of the present invention

In view of the problems in the existing technology, the present disclosure provides a semiconductor device assembly, a crimping-type power semiconductor module and manufacturing methods therefor, in which a current bypass structure is provided, such that when a certain conductor chip fails, the bypass structure in parallel with the chip can continue to provide a conduction path for a heavy current, thereby improving the capacity of the bypass structure for conducting the current in case of failure.

In a first aspect, the present disclosure provides a semiconductor device assembly, comprising a main circuit subassembly and a gate subassembly, the main circuit subassembly comprises a plurality of main circuit conductive mechanisms and a main circuit bypass mechanism, and each of the main circuit conductive mechanisms comprises a semiconductor chip and a main circuit conductive pillar having one end in contact with the semiconductor chip through a pad; wherein the main circuit bypass mechanism has an one-piece structure and is sleeved onto a plurality of main circuit conductive pillars to form a parallel connection with each of the main circuit conductive pillars. In the semiconductor device assembly, bypass structures of all chips are communicated such that when a certain conductor chip fails, a bypass structure in parallel with the chip can continue to provide a conduction path for a heave current, and an magnitude of the current conducted can be increased by means of a short-circuit structure, thereby improving a capacity of the bypass structure for conducting the current in case of failure.

In a possible implementation of the first aspect, the main circuit bypass mechanism comprises: a plurality of main circuit bypass elements, in which each main circuit bypass element is arc-shaped and has both ends thereof sleeved onto a related main circuit conductive pillar to form a parallel connection; wherein the plurality of the main circuit bypass elements are connected by means of a short-circuit element to form an integrated structure; or the plurality of main circuit bypass elements are formed as one piece. Through this implementation, two types of different main circuit bypass mechanisms are provided.

In a possible implementation of the first aspect, the semiconductor device assembly further comprises an insulation housing, a bottom plate, a gate lining plate, an insulation adhesive and an upper press plate, wherein bottom of the insulation housing is jointed to the bottom plate in a sealed manner, the semiconductor chips and the gate lining plate are arranged on an upper surface of the bottom plate and are connected with each other through bonding wires, the main circuit subassembly is fixedly installed inside the insulation housing, the insulation adhesive is filled inside the insulation housing, and the upper press plate is fixedly connected to another ends of the plurality of main circuit conductive pillars.

In a possible implementation of the first aspect, the main circuit subassembly further comprises a main circuit elastic force applying mechanism which includes a plurality of main circuit elastic force applying elements, and each of the main circuit elastic force applying elements is sleeved onto a related main circuit conductive pillar via a sleeve. Through this implementation, an elastic bypass mechanism can be formed, and the short-circuit structure can enable a conduction path for a heavy current without cutting down on an elastic pressure.

In a possible implementation of the first aspect, the gate subassembly comprises: a gate conductive pillar, having one end in contact with the gate lining plate; a gate bypass element, configured to be an arc shape and having both ends thereof sleeved onto the gate conductive pillar; and a gate elastic force applying element, sleeved onto the gate conductive pillar by means of a sleeve.

In a possible implementation of the first aspect, the bottom of the insulation housing is provided with a step structure, and the bottom plate is jointed to a step surface of the step structure in a sealed manner.

In a possible implementation of the first aspect, the main circuit elastic force applying elements and the gate elastic force applying element each are disc springs, hydraulic springs or spiral springs.

In a possible implementation of the first aspect, the main circuit bypass elements and the gate bypass element each are made of Cu or Al, and surfaces thereof are plated with tin, nickel or silver.

In a possible implementation of the first aspect, the main circuit conductive pillars and the gate conductive pillar each are made of Cu or Al, and surfaces thereof are plated with silver or nickel.

In a second aspect, the present disclosure further provides a crimping-type power semiconductor module, comprising a shell, a top plate, a gate PCB and at least one semiconductor device assembly as described in the first aspect and any one of the possible implementations thereof, wherein the top plate is connected with the shell in a sealed manner to form a cavity, at least one semiconductor device assembly is fixedly arranged inside the cavity through an elastic seal ring, and the gate PCB is arranged between the top plate and the at least one semiconductor device assembly in a crimping manner.

In a possible implementation of the second aspect, edges of both the top plate and top of the shell are provided with metal brims along a circumferential direction to achieve a sealing connection by argon arc welding, cold-press welding or sealant. Through this implementation, a better sealing performance of the semiconductor module is achieved.

In a possible implementation of the second aspect, the at least one the semiconductor device assembly is fixedly arranged inside the cavity through an elastic seal ring.

In a possible implementation of the second aspect, the elastic seal ring is made of an insulation material with ductility, and upper and lower surfaces thereof are connected in a sealed manner with the shell and the semiconductor device assembly, respectively, through adhesives.

In a possible implementation of the second aspect, the shell is formed by subjecting a composite fiber material to compression molding or injection molding process, and has an impact resistance strength of greater than 100 KJ/m². Through this implementation, the impact resistance strength of the semiconductor module is enhanced such that it is possible to effectively prevent internal parts from splashing in case of failure and explosion of the module, thereby satisfying a requirement of a specific working condition.

In a third aspect, the present disclosure further provides a manufacturing method for the semiconductor device assembly as described in the first aspect and any one of the possible implementations thereof, comprising steps of: connecting the insulation housing to the bottom plate in a sealed manner; fixedly installing the main circuit subassembly and the gate subassembly inside the insulation housing; fixedly jointing the upper press plate to the main circuit subassembly; applying a rated pressure to the upper press plate, and filling insulation adhesive in a liquid state into the insulation housing under a condition of the rated pressure; and removing the pressure after the insulation adhesive is cured.

In a possible implementation of the third aspect, the main circuit subassembly and the gate subassembly are obtained by steps of: fixedly arranging the plurality of the semiconductor chips and the gate lining plate on the bottom plate by welding or sintering; connecting the gate lining plate with the plurality of the semiconductor chips by bonding process; fixedly arranging a pad on an upper surface of each of the semiconductor chips; arranging a main circuit conductive pillar on an upper surface of each pad to form a main circuit conductive structure, and arranging the gate conductive pillar on the gate lining plate; sleeving a main circuit elastic force applying element onto each of the main circuit conductive pillars, and sleeving the gate elastic force applying element onto the gate conductive pillar; and fixedly sleeving each of the main circuit bypass elements onto both ends of a related main circuit conductive pillar to form the main circuit subassembly, and fixedly sleeving the gate bypass element onto both ends of the gate conductive pillar to form the gate subassembly.

In a fourth aspect, the present disclosure further provides a manufacturing method for the crimping-type power module as described in the second aspect and any one of the possible implementations thereof, comprising steps of: obtaining semiconductor device assemblies by the manufacturing method as described in the third aspect and any one of the possible implementations thereof; fixedly arranging at least one of the semiconductor device assemblies inside the cavity of the shell; installing the gate PCB above the at least one of the semiconductor device assemblies; and installing the top plate on the shell in a sealed manner.

In a possible implementation of the fourth aspect, the elastic seal ring is placed in the shell before the at least one semiconductor device assembly is installed.

Compared with the existing technology, the semiconductor device assembly, the crimping-type power module, and manufacturing methods therefor provided by the present disclosure have the following beneficial effects:
1) The high-strength long-fiber polyester shell improves the explosion-proof performance;
2) The sealed internal environment for the chips effectively prevents external substances from entering the interior of the power semiconductor module to cause damage, thereby improving the reliability and service life of the module;
3) The optimized current bypass structure improves the current conduction capability and enhances the capability of the module for triggering short-circuit in case of failure;
4) The setting of a specific spring deformation amount makes the chips bear a uniform force, thereby improving the electrical current equalization and thermal flow equalization performances of the module, and improving the reliability and service life of the module; and
5) The upper press plate suppress arc generated inside the module, thereby improving the reliability and service life of the module.

The above technical features may be combined in various suitable ways or replaced by equivalent technical features as long as the objectives of the present disclosure may be achieved.

### Brief Description of the Drawings

The present disclosure will be described in more detail below based on the embodiments with reference to the accompanying drawings, in which:
Fig. 1 shows an exploded diagram of a structure of a crimping-type power module according to an embodiment of the present disclosure;
Fig. 2 shows a sectional diagram of a crimping-type power module according to another embodiment of the present disclosure;
Fig. 3 shows an exploded diagram of a structure of a semiconductor device assembly according to an embodiment of the present disclosure;
Fig. 4 shows a sectional diagram of a semiconductor device assembly according to an embodiment of the present disclosure;
Fig. 5 shows a schematic diagram of assembling of main circuit conductive mechanisms and main circuit bypass mechanisms according to an embodiment of the present disclosure;
Fig. 6 shows a schematic diagram of a structure of a main circuit bypass mechanism according to an embodiment of the present disclosure;
Figs. 7 and 8 show schematic diagrams of force analysis for a crimping-type power semiconductor module according to an embodiment of the present disclosure before and after press fitting, respectively;
Fig. 9 shows a schematic flowchart of a manufacturing method for a semiconductor device assembly according to an embodiment of the present disclosure; and
Fig. 10 shows a schematic flowchart of a manufacturing method for a crimping-type power module according to an embodiment of the present disclosure.

In the drawings, identical components are indicated by an identical reference numeral. The drawings are drawn according to a non-actual scale.

### List of reference numerals:

100-crimping-type power module; 110-top plate; 120-shell; 130-semiconductor device assembly; 140-gate PCB; 150-elastic seal ring; 111-top plate metal brim; 121-shell metal brim; 122-subassembly installation region; 131-insulation housing; 132-bottom plate; 133-semiconductor chip; 133A-chip gate plate; 134-pad; 135-gate lining plate; 136-gate lead wire; 137-upper press plate; 138-insulation adhesive; 200-main circuit subassembly; 300-gate subassembly; 210-main circuit conductive mechanism; 220-main circuit bypass mechanism; 221-main circuit bypass element; 211-main circuit conductive pillar; 230-main circuit elastic force applying mechanism; 231-main circuit elastic force applying element; 232-sleeve; 300-gate subassembly; 310-gate conductive pillar; 320-gate bypass element; 330-gate elastic force applying element; 400-spring structure; 500-short-circuit element.

### Detailed Description of the Embodiments

Hereafter, the present disclosure will be further illustrated in conjunction with the accompanying drawings.

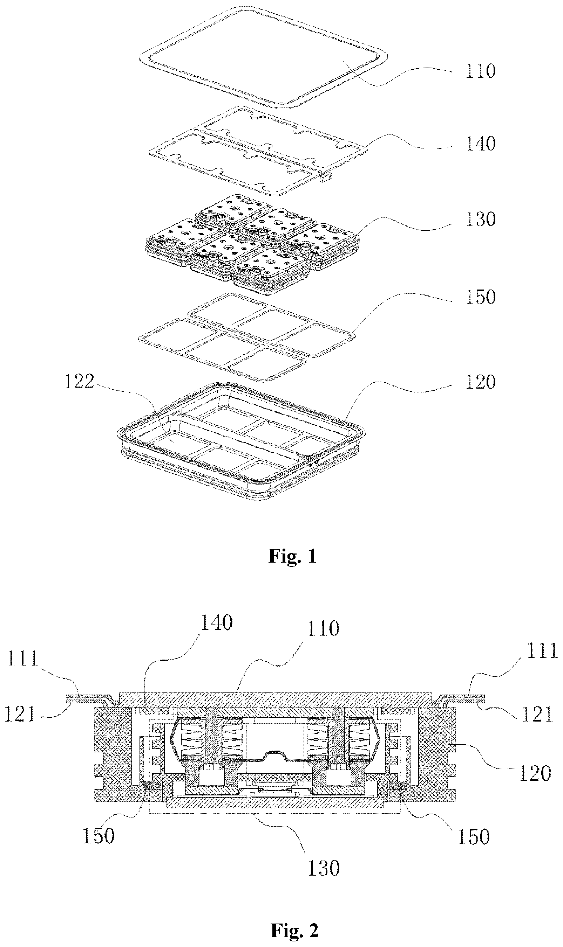

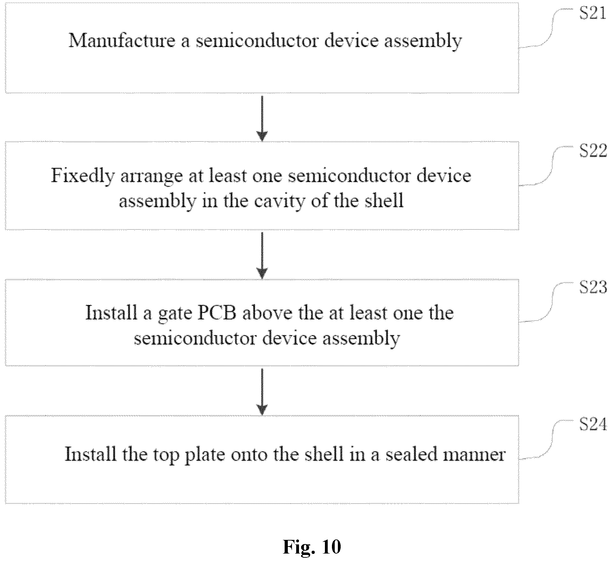

Fig. 1 shows an exploded diagram of a structure of a crimping-type power module 100 as provided in the present disclosure, and Fig. 10 shows a manufacturing method S21-S24 for the crimping-type power module 100. As shown in Fig. 1, the crimping-type power module 100 may comprise a top plate 110, a shell 120, at least one semiconductor device assembly 130, and a gate PCB 140. In combination with Fig. 10, the top plate 110 and the shell 120 are jointed in an sealed manner to form a sealed cavity, and at least one semiconductor subassembly 130 and the gate PCB 140 are fixedly installed in the cavity in a crimping-type manner to form a crimping-type power module with a large power capacity.

Specifically, as shown in Fig. 2, a top plate metal brim 111 is provided at the edge of the top plate 110 in a circumferential direction, and a shell metal brim 121 is provided at the edge of the shell 120 in a circumferential direction. When the cavity is formed by assembling, the top plate metal brim 111 and the shell metal brim 121 can be sealed as a whole by some connection means (such as argon arc welding, cold-press welding, and sealant bonding). Here, the top plate metal brim 111 should have the same size as the shell metal brim 121, and preferably, the two have complementary bending portions with each other to form a good sealing fit.

In a preferred embodiment, the top plate 110, as an electrical connection structure and a pressure bearing structure to which an external pressure is applied, may be made of a material having good electric conductivity and thermal conductivity and a certain rigidity, such as Cu, Mo or Cu-Mo alloy.

As shown in Fig. 1, at least one subassembly installation region 122 for accommodating the semiconductor device assembly 130 is distributed inside the shell 120 in an array form, and a size of each subassembly installation region 122 should be substantially the same as that of its related semiconductor device assembly 130. In a preferred embodiment, in addition to the functions of positioning and assembling the internal parts, the shell 120 per se is required to have a high impact resistance strength, which is generally greater than 100 KJ/m². For example, the shell 120 may be obtained by subjecting a reinforced composite fiber material to compression molding or injection molding such that it can effectively prevent the internal parts from splashing in case of failure and explosion of the module, thereby achieving an explosion-proof effect.

As a leading-out carrier of gate signals of chips, the gate PCB 140 is usually connected in a pressure-bearing contact manner to a gate conductive pillar (to be described in detail later) related to the chips of at least one semiconductor device assembly 130, and the surface of a pressed portion thereof is plated with gold or both nickel and gold so as to improve the stability of contact between interfaces.

As shown in Figs. 1 and 2, in a preferred embodiment, the crimping-type power module 100 may further comprise an elastic seal ring 150, which may be installed between the shell 120 and semiconductor device assemblies 130 in the shell 120, and is made of an insulation material with high strength and high ductility. The upper and lower surfaces of the elastic seal ring 150 are attached with bonding layers of high viscosity adhesive, respectively, or the elastic seal ring 150 per se is subjected to high-temperature melting treatment to form bonding layers, so as to achieve a sealing connection between the shell 120 and the semiconductor device assemblies 130, thereby enhancing the sealing performance of the power module.

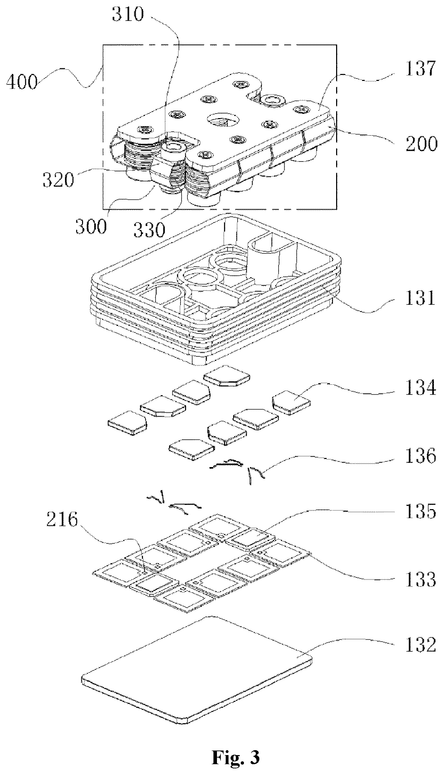

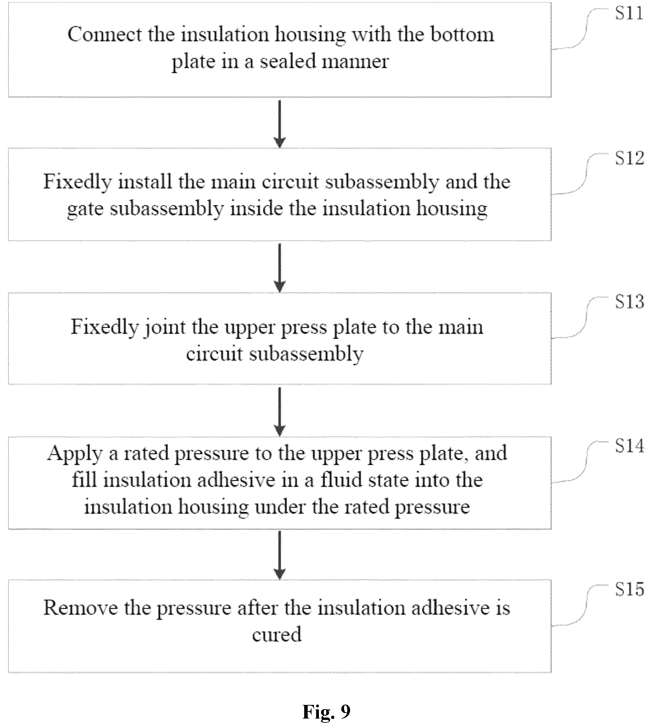

Fig. 3 clearly shows a structure of a semiconductor device assembly 130, which comprises an insulation housing 131, a bottom plate 132, a plurality of semiconductor chips 133, a plurality of pads 134, gate lining plates 135, gate lead wires 136, and a spring structure 400 including an upper press plate 137, main circuit subassemblies 200 and gate subassemblies 300. Specifically, when the semiconductor assembly 130 is assembled, as shown in Fig. 9, at S11, the bottom of the insulation housing 131 is jointed with the bottom plate 132 in a sealed manner to form a cavity in which the bottom is sealed and the top is opened for accommodating the spring structure 400. At S12, the main circuit subassemblies 200 and the gate subassemblies 300 are fixedly installed inside the insulation housing 131 and distributed on the bottom plate 132; at S13, the upper press plate 137 is fixedly jointed to the main circuit subassemblies 200; at S14, a rated pressure is applied to the upper press plate 137, and an insulation adhesive 138 in a liquid state is filled into the insulation housing 131 under a condition of the rated pressure state; and at S15, the above rated pressure is removed after the insulation adhesive 138 is cured (by being placed in a high-temperature curing furnace).

Here, the insulation housing 131 may be made of a high temperature resistant polyester material having a tolerable temperature of 150 ° C or higher. Before cured, the insulation adhesive 138 is in a semi liquid state with good fluidity, and can be well filled into gaps in the cavity inside the assembly, thereby ensuring good insulation requirements and satisfying an insulation index≥ 20 KV/mm.

According to a power level that is desired, a plurality of above semiconductor device assemblies 130 may be arranged in the crimping-type power module 100 as provided in the present disclosure, and different numbers of semiconductor chips 133 may also be arranged in a semiconductor device assembly 130. A plurality of (in Fig. 3, there is eight, which are divided into two groups) semiconductor chips 133 are arranged side by side on the bottom plate 132. There is a gap reserved between chips to ensure insulation requirement. The lower surface of each chip may be welded or silver sintered to the upper surface of the bottom plate 132. Meanwhile, the upper surface of each chip may further be connected to the pad 134 by welding or silver sintering. In the field of semiconductor, the technical term of this process is called "chip double-sided welding" or "chip double-sided silver sintering".

Preferably, thermal expansion coefficients of the bottom plate 132 and the pad 134 are both required to match with that of the semiconductor chip 133 (usually made of a silicon material) so as to prevent shedding due to inconsistent deformations in a high temperature environment. For example, a material for making them may be Mo or Mo-Cu alloy.

As a structure for collecting gate signals of all the semiconductor chips, the gate lining plate 135 may be welded or sintered to the upper surface of the bottom plate 132, and connected with chip gate plates (gate PADs) 133A of the semiconductor chips 133 via the gate lead wires 136 by bonding process to transmit gate signals of the chips. Here, the gate lead wire 136 is generally made of a material such as Al or Cu, and generally has a diameter of 5-30 mil.

In Fig. 3, an interior of the insulation housing may be roughly divided into a main circuit installation region and gate installation regions. In the main circuit installation region, circular ring structures of a plurality of main circuit conductive pillars (to be described in detail later) are distributed, and in each of the gate installation regions, an inner cavity of at least one gate conductive pillar (to be described in detail later) is distributed, so that it is possible to ensure fixing of the main circuit subassemblies 200 and the gate subassemblies 300 as well as isolation therebetween.

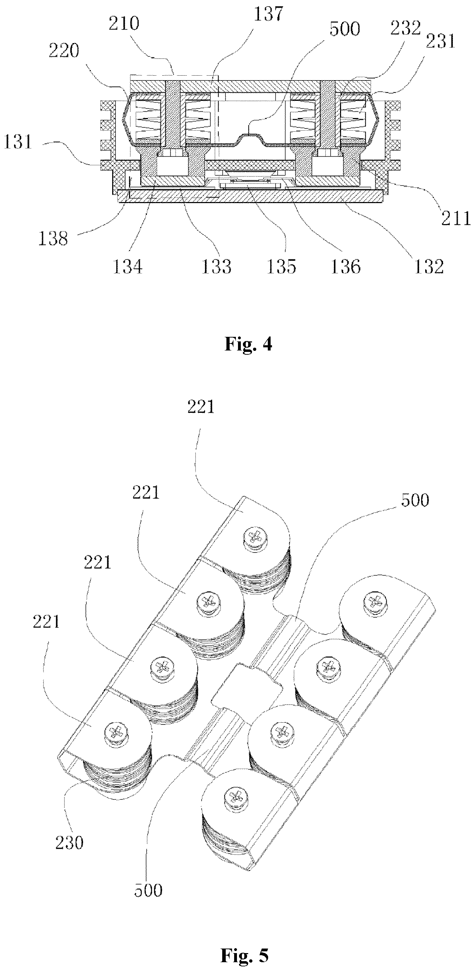

Hereafter, the main circuit subassemblies 200 as provided in the present disclosure will be described with reference to Figs. 3 and 4.

As shown in Fig. 4, the main circuit subassemblies 200 are fixedly installed inside a cavity enclosed by the insulation housing 131 and the bottom plate 132. A main circuit subassembly 200 comprises a plurality of main circuit conductive mechanisms 210, a main circuit bypass mechanism 220, and a main circuit elastic force applying mechanism 230 (Fig. 5).

Specifically, a main circuit conductive mechanism 210 comprises, from bottom to top, a semiconductor chip 133, a pad 134 and a main circuit conductive pillar 211. As described above, each semiconductor chip 133 is provided on its upper surface with a related pad 134 in a fixed manner, and the upper surface of each pad 134 is in contact with one end of a related main circuit conductive pillar 211. In this way, there are a plurality of main circuit subassemblies 200 formed as the same distribution pattern as that of the chips in the inner cavity of the insulation housing 131. A sleeve 232 is sleeved onto each main circuit conductive pillar 211, and a main circuit elastic force applying element 231 is sleeved onto the sleeve 232. The main circuit elastic force applying elements 231 of the plurality of main circuit conductive mechanisms 210 and the sleeves 232 together form the main circuit elastic force applying mechanism 230 of the main circuit subassembly 200. The force applying mechanism cooperates with the upper press plate 137 to form a crimping-type contact with the semiconductor chips 133.

In order to solve the problem of current conduction in case of failure of a chip, each main circuit conductive mechanism 210 is equipped with a main circuit bypass element 221 (Fig. 5), which is arc-shaped and sleeved onto the main circuit conductive pillar 211 of each main circuit conductive mechanism 210 to form a parallel connection with a related semiconductor chip 133. When the chip fails, the current can flow through this bypass element, thereby avoiding formation of an open circuit.

The respective main circuit bypass elements 211 of the plurality of main circuit conductive mechanisms 210 together form the main circuit bypass mechanism 220. As shown in Figs. 4 to 6, in the semiconductor device assembly 130 as provided in the present disclosure, the main circuit bypass mechanism 220 is an one-piece formed structure, that is, respective main circuit bypass elements 211 are communicated with each other, rather than being separate elements independent of each other. In this way, the problem of formation of an open circuit can be avoided, and it is also possible to avoid formation of an isolation layer with high resistance due to melting and carbonization of a separate bypass element caused by large current conduction path in a high-power power module. Those skilled in the art should understand that in the crimping-type power module, there is usually a high requirement to the elasticity of the elastic force applying mechanism, that is, it is essential to ensure the elasticity of the elastic force applying mechanism. However, in the existing technology, the main circuit bypass elements 221 are independent of each other so that the only approach to improve the current conduction performance is to increase a thickness and a size of the main circuit bypass element 221. As a result, obviously, a size of an elastic force applying structure has been cut down in the power module with a limited space, which is obviously undesirable. Accordingly, according to the embodiment of the present disclosure, with a guarantee of the elasticity of the elastic force applying mechanism, it is also possible to increase/expand the size of the bypass mechanism and the current conduction path by allowing the plurality of main circuit bypass elements 221 to communicate with each other, thereby improving current conduction capacity.

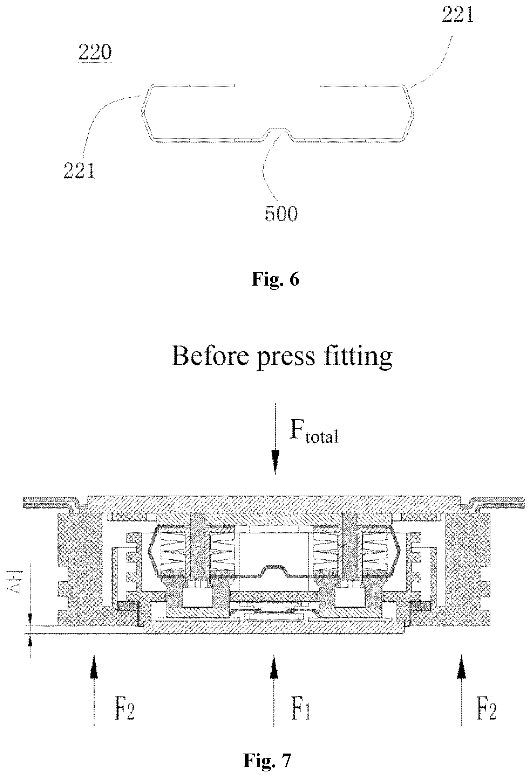

Optionally, the main circuit bypass mechanism 220 may be an integrated structure in various forms. For example, the plurality of main circuit bypass elements 211 are formed separately, and then are connected together by means of a short-circuit element 500 to form the integrated structure; and for another example, the main circuit bypass mechanism 220 may be formed as one piece (as shown in Figs. 5 and 6), which can avoid the problems in terms of connection stability and process complexity that may occur in the former way.

In the exemplary embodiments as shown in Figs. 3 and 5, the semiconductor device assembly 130 comprises 8 semiconductor chips, which are divided into two groups to be distributed on the bottom plate 132. The main circuit bypass mechanism 220 is C-shaped and is formed as a one-piece structure, on which a plurality of sockets for respective main circuit conductive pillars 211 are provided. Four main circuit bypass elements 221 in each group are firstly connected as a whole and then are connected by at least one short-circuit element 500 intervened therebetween to form into an integrated structure. By means of the short-circuit element 500 intervened, the current conduction capacity can be further improved by increasing a thickness of the intervening short-circuit element 500.

Fig. 3 also shows a schematic diagram of a structure of a gate subassembly 300, comprising the following components:
a gate conductive pillar 310, having one end thereof in contact with the gate lining plate 135;
a gate bypass element 320, configured to be an arc shape and having both ends thereof sleeved onto the gate conductive pillar 310; and
a gate elastic force applying element 330, sleeved onto the gate conductive pillar 310 via a sleeve 232.

Preferably, the main circuit conductive pillar 211 and the gate conductive pillar 310 are used as pressure-bearing contact elements of a main current conduction path. The two are usually made of a material such as copper, aluminum or their alloy with excellent conductivity, and are subjected to surface treatment by silver plating, nickel plating, etc.

Preferably, the main circuit bypass element 221 and the gate bypass element 320 are used as main paths for current conduction. The two are usually made of a material such as copper sheet and aluminum sheet, etc. and are subjected to surface treatment by tin plating, nickel plating or silver plating. A thickness of the bypass busbar may be flexibly adjusted according to a magnitude of the current.

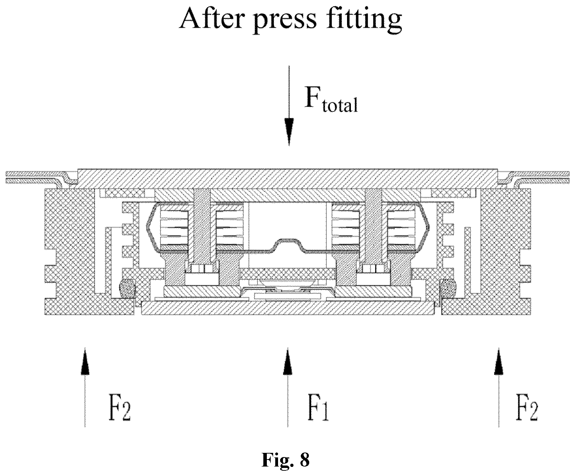

After the main circuit subassemblies 200 and the gate subassemblies 300 are formed, as shown in Figs. 3 and 4, the main circuit subassembles 200 are fixedly jointed to the upper press plate 137. Specifically, the other end of each main circuit conductive pillar 211 is fixedly jointed into a through hole which is provided on the upper press plate 137. Since each main circuit conductive pillar 211 has the same length, the upper press plate 137 can be maintained to be in a horizontal plane in an assembly state. In an embodiment of the application, as shown in Figs. 7 and 8, a spring structure 400 is configured to enable a uniform force to be borne among the semiconductor chips. A pressure onto a chip completely depends on a deformation amount △H of the spring structure, and will not change along with the change of an external pressure. Thus, pressure uniformity among chips can be completely ensured. When the module is subjected to an external press fitting force "Fₜₒₜₐₗ", a force applied to the interior of the module is divided into two components, i.e., "F1-acting force against chips" and "F2-acting force against pressure-bearing injection molded elements", wherein F1 is provided by a counteraction elastic force generated by the deformation amount △H of a spring, that is, F1=k*△H, and F2 = Fₜₒₜₐₗ - F1. Therefore, when the external press fitting force Fₜₒₜₐₗ changes, the force F1 applied to the chips is constant, thereby ensuring the use reliability of the module.

Preferably, serving as the pressure applying mechanism for a chip (the force applied to the chip is completely provided by an elastic force generated by the deformation of the mechanism, F=k*△H), the main circuit elastic force applying element 231 and the gate elastic force applying element 330 are preferably disc springs, hydraulic springs or spiral springs, and the number and a combination form of the springs may be flexibly configured according to a desired chip pressure.

In addition, the upper press plate 137, which is to be used as a conductive material having a low electron emission and having a melting temperature higher than that of the top plate 110, for example, is made of tungsten, chromium, nickel or other alloys, and can suppress arc generated between the bottom plate 132 and the upper press plate 137 such that the arc cannot reach the top plate 110.

The present disclosure provides a semiconductor device assembly, a crimping-type power module, and manufacturing methods therefor. The high-strength long-fiber polyester shell improves the explosion-proof performance; a sealed internal environment for the chips effectively prevents external substances from entering the power semiconductor module to cause damage, thereby improving the reliability and service life of the module; the optimized current bypass structure improves the current conduction capability and enhances the capability of the module for triggering short-circuit in case of failure ; the setting of specific spring deformation amount makes the chips bear an uniform force, thereby improving electrical current equalization and thermal flow equalization performances of the module, and improving the reliability and service life of the module; and the upper press plate suppress arc inside the module, thereby improving the reliability and service life of the module.

In the description of the present disclosure, it should be understood that the orientation or position relationships indicated by the terms "upper", "lower", "bottom", "top", "front", "rear", "inside", "outside", "left", "right", etc. are the orientation or position relationships shown on the basis of the drawings, which are only for convenience of describing the present disclosure and simplifying the description, but are not intended to indicate or imply that the device or element indicated must have a specific orientation, must be constructed and operated in a specific orientation. Therefore, they should not to be construed as limitation to the present disclosure.

Although the present disclosure is described herein with reference to specific embodiments, it should be understood that these embodiments are only examples of the principle and practice of the present disclosure. Therefore, it should be understood that various modifications may be made to the exemplary embodiments and other arrangements may be designed as long as they do not depart from the scope of the present disclosure defined by the appended claims.

## Claims

1. A semiconductor device assembly (130), comprising a main circuit subassembly (200) and a gate subassembly (300), wherein the main circuit subassembly (200) comprises a plurality of main circuit conductive mechanisms (210) and a main circuit bypass mechanism (220), and each of the main circuit conductive mechanisms (210) comprises a semiconductor chip (133) and a main circuit conductive pillar (211) having one end in contact with the semiconductor chip through a pad (134);
wherein the main circuit bypass mechanism (220) has a one-piece structure and is sleeved onto a plurality of main circuit conductive pillars (211) to form a parallel connection with each of the main circuit conductive pillars (211).

2. The semiconductor device assembly according to claim 1, **characterized in that**, the main circuit bypass mechanism (220) comprises:
a plurality of main circuit bypass elements (221), each of the main circuit bypass elements being arc-shaped and having both ends thereof sleeved onto a related main circuit conductive pillar (211) to form a parallel connection;
wherein the plurality of the main circuit bypass elements are connected by means of a short-circuit element (500) to form an integrated structure; or the plurality of main circuit bypass elements are formed as one piece.

3. The semiconductor device assembly according to claim 1 or 2, **characterized in that**, the semiconductor device assembly (200) further comprises an insulation housing (131), a bottom plate (132), a gate lining plate (135), an insulation adhesive (138) and an upper press plate (137), wherein bottom of the insulation housing is jointed to the bottom plate in a sealed manner, semiconductor chips (133) and the gate lining plate are arranged on an upper surface of the bottom plate and are connected with each other through bonding wires (136), the main circuit subassembly is fixedly installed inside the insulation housing, the insulation adhesive is filled inside the insulation housing, and the upper press plate is fixedly connected with another ends of the plurality of main circuit conductive pillars (211).

4. The semiconductor device assembly according to claim 3, **characterized in that**, the main circuit subassembly (200) further comprises a main circuit elastic force applying mechanism (230) which includes a plurality of main circuit elastic force applying elements, and each of the main circuit elastic force applying elements (230) is sleeved onto a related main circuit conductive pillar (211) by means of a sleeve (232).

5. The semiconductor device assembly according to claim 3, **characterized in that**, the gate subassembly (300) comprises:
a gate conductive pillar (310), having one end in contact with the gate lining plate;
a gate bypass element (320), configured to be an arc shape and having both ends thereof sleeved onto the gate conductive pillar; and
a gate elastic force applying element (330), sleeved onto the gate conductive pillar by means of a sleeve (232).

6. The semiconductor device assembly according to claim 5, **characterized in that**, the main circuit elastic force applying elements (230) and the gate elastic force applying element (330) each are disc springs, hydraulic springs or spiral springs.

7. The semiconductor device assembly according to claim 5, **characterized in that**, the main circuit bypass elements (221) and the gate bypass element (320) each are made of Cu or Al, and surfaces thereof are plated with tin, nickel or silver.

8. The semiconductor device assembly according to claim 5, **characterized in that**, the main circuit conductive pillars (211) and the gate conductive pillar (310) each are made of Cu or Al, and the surfaces thereof are plated with silver or nickel.

9. A crimping-type power semiconductor module (100), comprising a shell (120), a top plate (110), a gate PCB (140), and at least one semiconductor device assembly (130) according to any one of claims 1-8, wherein the top plate is connected with the shell in a sealed manner to form a cavity, at least one semiconductor device assembly is fixedly arranged inside the cavity, and the gate PCB is arranged between the top plate and the at least one semiconductor device assembly in a crimping manner.

10. The crimping-type power semiconductor module according to claim 9, **characterized in that**, edges of both the top plate (110) and top of the shell (120) are provided with metal brims (111, 121) along a circumferential direction to enable a sealing connection.

11. The crimping-type power semiconductor module according to claim 9 or 10, **characterized in that**, the shell (120) is formed by subjecting a composite fiber material to compression molding or injection molding process, and has an impact resistance strength of greater than 100 KJ/m².

12. The crimping-type power semiconductor module according to claim 9 or 10, **characterized in that**, the at least one the semiconductor device assembly (130) is fixedly arranged inside the cavity by means of an elastic seal ring (150).

13. The crimping-type power semiconductor module according to claim 12, **characterized in that**, the elastic seal ring (150) is made of an insulation material with ductility, and upper and lower surfaces of the elastic seal ring are connected in a sealed manner with the shell (120) and the semiconductor device assembly (130), respectively, through adhesives.

14. A manufacturing method for the semiconductor device assembly according to any one of claims 3 to 8, comprising steps of:
connecting the insulation housing to the bottom plate in a sealed manner (S11);
fixedly installing the main circuit subassembly and the gate subassembly inside the insulation housing (S12);
fixedly jointing the upper press plate to the main circuit subassembly (S13);
applying a rated pressure to the upper press plate, and filling insulation adhesive in a liquid state into the insulation housing under a condition of the rated pressure (S14); and
removing the pressure after the insulation adhesive is cured (S15).

15. The manufacturing method according to claim 14, **characterized in that**, the main circuit subassembly and the gate subassembly are obtained by steps of:
fixedly arranging a plurality of semiconductor chips and the gate lining plate on the bottom plate by welding or sintering;
connecting the gate lining plate with the plurality of the semiconductor chips by bonding process;
fixedly arranging a pad on an upper surface of each of the semiconductor chips;
arranging a main circuit conductive pillar on an upper surface of each pad to form a main circuit conductive structure, and arranging the gate conductive pillar on the gate lining plate;
sleeving a main circuit elastic force applying element onto each of the main circuit conductive pillars, and sleeving the gate elastic force applying element onto the gate conductive pillar; and
fixedly sleeving each of the main circuit bypass elements onto both ends of a related main circuit conductive pillar to form the main circuit subassembly, and fixedly sleeving the gate bypass element onto both ends of the gate conductive pillar to form the gate subassembly.

16. A manufacturing method for the crimping-type power module according to any one of claims 9 to 13, comprising steps of:
obtaining semiconductor device assemblies by the manufacturing method according to claim 14 or 15 (S21);
fixedly arranging at least one of the semiconductor device assemblies inside the cavity of the shell (S22);
installing the gate PCB above the at least one of the semiconductor device assemblies (S23); and
installing the top plate onto the shell in a sealed manner (S24).

17. The manufacturing method according to claim 16, **characterized in that**, the elastic seal ring is placed in the shell before the at least one of the semiconductor device assemblies is installed.

## Patentansprüche

1. Halbleiterbauelementanordnung (130), umfassend eine Hauptstromkreisunterbaugruppe (200) und eine Gatterunterbaugruppe (300), worin die Hauptstromkreisunterbaugruppe (200) eine Vielzahl von Hauptstromkreisleitungsmechanismen (210) und einen Hauptstromkreisumgehungsmechanismus (220) umfasst, und jeder von den Hauptstromkreisleitungsmechanismen (210) einen Halbleiterchip (133) und einen Hauptstromkreisleitungspfeiler (211) umfasst, der ein Ende im Kontakt mit dem Halbleiterchip über ein Pad (134) aufweist;
worin der Hauptstromkreisumgehungsmechanismus (220) eine einteilige Struktur hat und auf eine Vielzahl von Hauptstromkreisleitungspfeilern (211) aufgesteckt ist, um eine parallele Verbindung mit jedem der Hauptstromkreisleitungspfeiler (211) zu bilden.

2. Halbleiterbauelementanordnung nach Anspruch 1, **dadurch gekennzeichnet, dass** der Hauptstromkreisumgehungsmechanismus (220) umfasst:
eine Vielzahl von Hauptstromkreisumgehungselementen (221), wobei jedes von den Hauptstromkreisumgehungselementen bogenförmig ist und beide Enden davon hat, die auf einen dazugehörigen Hauptstromkreisleitungspfeiler (211) aufgesteckt sind, um eine parallele Verbindung zu bilden;
worin die Vielzahl der Hauptstromkreisumgehungselemente mittels eines Kurzschlusselementes (500) verbunden sind, um eine integrierte Struktur zu bilden; oder die Vielzahl von Hauptstromkreisumgehungselementen als ein einziges Teil ausgebildet sind.

3. Halbleiterbauelementanordnung nach Anspruch 1 oder 2, **dadurch gekennzeichnet, dass** die Halbleiterbauelementanordnung (200) ferner ein Isolationsgehäuse (131), eine Bodenplatte (132), eine Gatterauskleidungsplatte (135), einen Isolationsklebstoff (138) und eine obere Druckplatte (137) umfasst, worin der Boden des Isolationsgehäuses mit der Bodenplatte in einer abgedichteten Weise zusammengefügt ist, Halbleiterchips (133) und die Gatterauskleidungsplatte an einer oberen Fläche der Bodenplatte angeordnet sind und miteinander über Bonddrähte (136) verbunden sind, die Hauptstromkreisunterbaugruppe innerhalb des Isolationsgehäuses fest installiert ist, der Isolationsklebstoff innerhalb des Isolationsgehäuses gefüllt ist, und die obere Druckplatte mit einem anderen Ende von der Vielzahl von Hauptstromkreisleitungspfeilern (211) fest verbunden ist.

4. Halbleiterbauelementanordnung nach Anspruch 3, **dadurch gekennzeichnet, dass**, die Hauptstromkreisunterbaugruppe (200) ferner einen Hauptstromkreisfederkraftaufbringungsmechanismus (230) umfasst, der eine Vielzahl von Hauptstromkreisfederkraftaufbringungselementen umfasst, und jedes von den Hauptstromkreisfederkraftaufbringungselementen (230) auf einen dazugehörigen Hauptstromkreisleitungspfeiler (211) über eine Hülse (232) aufgesteckt ist.

5. Halbleiterbauelementanordnung nach Anspruch 3, **dadurch gekennzeichnet, dass** die Gatterunterbaugruppe (300) umfasst:
einen Gatterleitungspfeiler (310), der ein Ende im Kontakt mit der Gatterauskleidungsplatte aufweist;
ein Gatterumgehungselement (320), das dafür ausgelegt ist, bogenförmig zu sein, und das beide Enden davon hat, die auf den Gatterleitungspfeiler aufgesteckt sind; und
ein Gatterfederkraftaufbringungselement (330), das auf den Gatterleitungspfeiler über eine Hülse (232) aufgesteckt ist.

6. Halbleiterbauelementanordnung nach Anspruch 5, **dadurch gekennzeichnet, dass** die Hauptstromkreisfederkraftaufbringungselemente (230) und das Gatterfederkraftaufbringungselement (330) je Tellerfedern, Hydraulikfedern oder Spiralfedern sind.

7. Halbleiterbauelementanordnung nach Anspruch 5, **dadurch gekennzeichnet, dass** die Hauptstromkreisumgehungselemente (221) und das Gatterumgehungselement (320) je aus Cu oder Al bestehen, und die Flächen davon mit Zinn, Nickel oder Silber überzogen sind.

8. Halbleiterbauelementanordnung nach Anspruch 5, **dadurch gekennzeichnet, dass** die Hauptstromkreisleitungspfeiler (211) und der Gatterleitungspfeiler (310) je aus Cu oder Al bestehen, und die Flächen davon mit Silber oder Nickel überzogen sind.

9. Crimp-Leistungshalbleitermodul (100), umfassend eine Schale (120), eine Oberplatte (110), eine Gatter-Leiterplatte (140) und zumindest eine Halbleiterbauelementanordnung (130) nach einem der Ansprüche 1-8, worin die Oberplatte mit der Schale in einer abgedichteten Weise verbunden ist, um einen Hohlraum zu bilden, zumindest eine Halbleiterbauelementanordnung innerhalb des Hohlraums fest angeordnet ist, und die Gatter-Leiterplatte zwischen der Oberplatte und der zumindest einen Halbleiterbauelementanordnung in einer crimpenden Weise angeordnet ist.

10. Crimp-Leistungshalbleitermodul nach Anspruch 9, **dadurch gekennzeichnet, dass** die Ränder sowohl der Oberplatte (110) als auch des Oberteils der Schale (120) mit Metallkrempen (111, 121) entlang einer Umfangsrichtung versehen sind, um eine Dichtverbindung zu ermöglichen.

11. Crimp-Leistungshalbleitermodul nach Anspruch 9 oder 10, **dadurch gekennzeichnet, dass** die Schale (120) dadurch gebildet wird, dass ein Verbundfasermaterial einem Formpress- oder Spritzgießvorgang unterzogen wird, und eine Stoßfestigkeit höher als 100 KJ/m² hat.

12. Crimp-Leistungshalbleitermodul nach Anspruch 9 oder 10, **dadurch gekennzeichnet, dass** die zumindest eine Halbleiterbauelementanordnung (130) innerhalb des Hohlraums mittels eines elastischen Dichtringes (150) fest angeordnet ist.

13. Crimp-Leistungshalbleitermodul nach Anspruch 12, **dadurch gekennzeichnet, dass** der elastische Dichtring (150) aus einem Isolationsmaterial mit Duktilität hergestellt ist, und obere und untere Flächen des elastischen Dichtringes in einer abgedichteten Weise jeweils mit der Schale (120) und der Halbleiterbauelementanordnung (130) über Klebstoffe verbunden sind.

14. Herstellungsverfahren für die Halbleiterbauelementanordnung nach einem der Ansprüche 3 bis 8, umfassend die Schritte:
Verbinden des Isolationsgehäuses mit der Bodenplatte in einer abgedichteten Weise (S11);
festes Installieren der Hauptstromkreisunterbaugruppe und der Gatterunterbaugruppe innerhalb des Isolationsgehäuses (S12);
festes Zusammenfügen der oberen Druckplatte mit der Hauptstromkreisunterbaugruppe (S13);
Aufbringen eines Nenndruckes auf die obere Druckplatte, und Füllen von Isolationsklebstoff in einem flüssigen Zustand in das Isolationsgehäuse unter einer Bedingung des Nenndruckes (S14); und
Entfernen des Druckes nachdem der Isolationsklebstoff ausgehärtet ist (S15).

15. Herstellungsverfahren nach Anspruch 14, **dadurch gekennzeichnet, dass** die Hauptstromkreisunterbaugruppe und die Gatterunterbaugruppe durch die Schritte erhalten werden:
festes Anordnen einer Vielzahl von Halbleiterchips und der Gatterauskleidungsplatte auf der Bodenplatte durch Schweißen oder Sintern;
Verbinden der Gatterauskleidungsplatte mit der Vielzahl von Halbleiterchips durch Bindungsvorgang;
festes Anordnen eines Pads auf einer oberen Fläche jedes der Halbleiterchips;
Anordnen eines Hauptstromkreisleitungspfeilers auf einer oberen Fläche jedes Pads, um eine Hauptstromkreisleitstruktur zu bilden, und Anordnen des Gatterleitungspfeilers auf der Gatterauskleidungsplatte;
Aufstecken eines Hauptstromkreisfederkraftaufbringungselementes auf jeden der Hauptstromkreisleitungspfeiler, und Aufstecken des Gatterfederkraftaufbringungselementes auf den Gatterleitungspfeiler; und
festes Aufstecken jedes der Hauptstromkreisumgehungselemente auf die beiden Enden eines dazugehörigen Hauptstromkreisleitungspfeilers, um die Hauptstromkreisunterbaugruppe zu bilden, und festes Aufstecken des Gatterumgehungselementes auf beide Enden des Gatterleitungspfeilers, um die Gatterunterbaugruppe zu bilden.

16. Herstellungsverfahren für das Crimp-Leistungsmodul nach einem der Ansprüche 9 bis 13, umfassend die Schritte:
Erhalten von Halbleiterbauelementanordnungen durch das Herstellungsverfahren nach Anspruch 14 oder 15 (S21);
festes Anordnen zumindest einer der Halbleiterbauelementanordnungen innerhalb des Hohlraums der Schale (S22);
Installieren der Gatter-Leiterplatte über der zumindest einen der Halbleiterbauelementanordnungen (S23); und
Installieren der Oberplatte auf der Schale in einer abgedichteten Weise (S24).

17. Herstellungsverfahren nach Anspruch 16, **dadurch gekennzeichnet, dass** der elastische Dichtring in der Schale gestellt wird, bevor die zumindest eine der Halbleiterbauelementanordnungen installiert ist.

## Revendications

1. Ensemble dispositif à semi-conducteur (130), comprenant un sous-ensemble de circuit principal (200) et un sous-ensemble de grille (300), dans lequel le sous-ensemble de circuit principal (200) comprend une pluralité de mécanismes conducteurs de circuit principal (210) et un mécanisme de dérivation de circuit principal (220), et chacun des mécanismes conducteurs de circuit principal (210) comprend une puce semi-conductrice (133) et un pilier conducteur de circuit principal (211) ayant une extrémité en contact avec la puce semi-conductrice par l'intermédiaire d'un plot (134) ;
dans lequel le mécanisme de dérivation de circuit principal (220) présente une structure en une seule pièce et est emmanché sur une pluralité de piliers conducteurs de circuit principal (211) pour former une connexion parallèle avec chacun des piliers conducteurs de circuit principal (211).

2. Ensemble dispositif à semi-conducteur selon la revendication 1, **caractérisé en ce que** le mécanisme de dérivation de circuit principal (220) comprend :
une pluralité d'éléments de dérivation de circuit principal (221), chacun des éléments de dérivation de circuit principal étant en forme d'arc et ayant ses deux extrémités emmanchées sur un pilier conducteur de circuit principal (211) associé pour former une connexion parallèle ;
dans lequel la pluralité d'éléments de dérivation de circuit principal sont connectés au moyen d'un élément de court-circuit (500) pour former une structure intégrée ; ou la pluralité d'éléments de dérivation de circuit principal sont formés d'une seule pièce.

3. Ensemble dispositif à semi-conducteur selon la revendication 1 ou 2, **caractérisé en ce que**, l'ensemble dispositif à semi-conducteur (200) comprend en outre un boîtier d'isolation (131), une plaque de fond (132), une plaque de revêtement de grille (135), un adhésif d'isolation (138) et une plaque de pression supérieure (137), dans lequel le fond du boîtier d'isolation est joint à la plaque de fond de manière étanche, des puces semi-conductrices (133) et la plaque de revêtement de grille sont agencées sur une surface supérieure de la plaque de fond et sont connectées les unes aux autres par l'intermédiaire de fils de liaison (136), le sous-ensemble de circuit principal est installé de manière fixe à l'intérieur du boîtier d'isolation, l'adhésif d'isolation est introduit à l'intérieur du boîtier d'isolation, et la plaque de pression supérieure est connectée de manière fixe à d'autres extrémités de la pluralité de piliers conducteurs de circuit principal (211).

4. Ensemble dispositif à semi-conducteur selon la revendication 3, **caractérisé en ce que** le sous-ensemble de circuit principal (200) comprend en outre un mécanisme d'application de force élastique de circuit principal (230) qui comprend une pluralité d'éléments d'application de force élastique de circuit principal, et chacun des éléments d'application de force élastique de circuit principal (230) est emmanché sur un pilier conducteur de circuit principal (211) associé au moyen d'un manchon (232).

5. Ensemble dispositif à semi-conducteur selon la revendication 3, **caractérisé en ce que** le sous-ensemble de grille (300) comprend :
un pilier conducteur de grille (310), comportant une extrémité en contact avec la plaque de revêtement de grille ;
un élément de dérivation de grille (320), configuré pour présenter une forme d'arc et dont les deux extrémités sont emmanchées sur le pilier conducteur de grille ; et
un élément d'application de force élastique de grille (330), emmanché sur le pilier conducteur de grille au moyen d'un manchon (232).

6. Ensemble dispositif à semi-conducteur selon la revendication 5, **caractérisé en ce que** les éléments d'application de force élastique de circuit principal (230) et l'élément d'application de force élastique de grille (330) sont chacun des ressorts à disque, des ressorts hydrauliques ou des ressorts en spirale.

7. Ensemble dispositif à semi-conducteur selon la revendication 5, **caractérisé en ce que** les éléments de dérivation de circuit principal (221) et l'élément de dérivation de grille (320) sont chacun constitués de Cu ou de Al, et leurs surfaces sont plaquées d'étain, de nickel ou d'argent.

8. Ensemble dispositif à semi-conducteur selon la revendication 5, **caractérisé en ce que** les piliers conducteurs de circuit principal (211) et le pilier conducteur de grille (310) sont chacun constitués de Cu ou de Al, et leurs surfaces sont plaquées d'argent ou de nickel.

9. Module semi-conducteur de puissance de type à sertissage (100), comprenant une coque (120), une plaque de dessus (110), une carte de circuit imprimé de grille (140), et au moins un ensemble dispositif à semi-conducteur (130) selon l'une quelconque des revendications 1 à 8, dans lequel la plaque supérieure est connectée à la coque de manière étanche pour former une cavité, au moins un ensemble dispositif à semi-conducteur est agencé de manière fixe à l'intérieur de la cavité, et la carte de circuit imprimé de grille est agencée entre la plaque supérieure et l'au moins un ensemble dispositif à semi-conducteur par sertissage.

10. Module semi-conducteur de puissance de type à sertissage selon la revendication 9, **caractérisé en ce que** des bords de la plaque de dessus (110) et du dessus de la coque (120) sont pourvus de rebords métalliques (111, 121) le long d'une direction circonférentielle pour permettre une connexion étanche.

11. Module semi-conducteur de puissance de type à sertissage selon la revendication 9 ou 10, **caractérisé en ce que** la coque (120) est formée en soumettant un matériau de fibre composite à un processus de moulage par compression ou de moulage par injection, et présente une résistance aux chocs supérieure à 100 KJ/m².

12. Module semi-conducteur de puissance de type à sertissage selon la revendication 9 ou 10, **caractérisé en ce que** l'au moins un ensemble dispositif à semi-conducteur (130) est agencé de manière fixe à l'intérieur de la cavité au moyen d'une bague d'étanchéité élastique (150).

13. Module semi-conducteur de puissance de type à sertissage selon la revendication 12, **caractérisé en ce que** la bague d'étanchéité élastique (150) est constituée d'un matériau d'isolation avec ductilité, et les surfaces supérieure et inférieure de la bague d'étanchéité élastique sont connectées de manière étanche à la coque (120) et à l'ensemble dispositif à semi-conducteur (130), respectivement, à travers des adhésifs.

14. Procédé de fabrication de l'ensemble dispositif à semi-conducteur selon l'une quelconque des revendications 3 à 8, comprenant les étapes consistant à :
connecter le boîtier d'isolation à la plaque inférieure de manière étanche (S11) ;
installer de manière fixe le sous-ensemble de circuit principal et le sous-ensemble de grille à l'intérieur du boîtier d'isolation (S12) ;
joindre de manière fixe la plaque de pression supérieure au sous-ensemble de circuit principal (S13) ;
appliquer une pression nominale à la plaque de pression supérieure, et introduire l'adhésif d'isolation à l'état liquide dans le boîtier d'isolation sous une condition de pression nominale (S14) ; et
supprimer la pression après le durcissement de l'adhésif d'isolation (S15).

15. Procédé de fabrication selon la revendication 14, **caractérisé en ce que** le sous-ensemble de circuit principal et le sous-ensemble de grille sont obtenus par les étapes consistant à :
agencer de manière fixe une pluralité de puces semi-conductrices et la plaque de revêtement de grille sur la plaque de fond par soudage ou frittage ;
connecter la plaque de revêtement de grille à la pluralité de puces semi-conductrices par un processus de liaison ;
agencer de manière fixe un plot sur une surface supérieure de chacune des puces semi-conductrices ;
agencer un pilier conducteur de circuit principal sur une surface supérieure de chaque plot pour former une structure conductrice de circuit principal, et agencer le pilier conducteur de grille sur la plaque de revêtement de grille ;
emmancher un élément d'application de force élastique de circuit principal sur chacun des piliers conducteurs de circuit principal, et emmancher l'élément d'application de force élastique de grille sur le pilier conducteur de grille ; et
emmancher de manière fixe chacun des éléments de dérivation de circuit principal sur les deux extrémités d'un pilier conducteur de circuit principal associé pour former le sous-ensemble de circuit principal, et emmancher de manière fixe l'élément de dérivation de grille sur les deux extrémités du pilier conducteur de grille pour former le sous-ensemble de grille.

16. Procédé de fabrication du module de puissance de type à sertissage selon l'une quelconque des revendications 9 à 13, comprenant les étapes consistant à :
obtenir des ensembles dispositifs à semi-conducteurs par le procédé de fabrication selon la revendication 14 ou 15 (S21) ;
agencer de manière fixe au moins l'un des ensembles dispositifs à semi-conducteurs à l'intérieur de la cavité de la coque (S22) ;
installer la carte de circuit imprimé de grille au-dessus de l'au moins un des ensembles dispositifs à semi-conducteurs (S23) ; et
installer la plaque de dessus sur la coque de manière étanche (S24).

17. Procédé de fabrication selon la revendication 16, **caractérisé en ce que** la bague d'étanchéité élastique est placée dans la coque avant l'installation de l'au moins un des ensembles dispositifs à semi-conducteurs.
